# EUROPÄISCHE PATENTSCHRIFT

(11) **EP 0 769 155 B1**
(45) Veröffentlichungstag und Bekanntmachung des Hinweises auf die Patenterteilung: **20.09.2000**
(21) Anmeldenummer: 95922413.0
(22) Anmeldetag: 26.06.1995
(51) Int. Cl.: G02B 6/43

(54) **Anordnung von optischen Baugruppen**
Arrangement of optical modules
Arrangement pour modules optiques

(30) Priorität: 06.07.1994 DE 4423735
(43) Veröffentlichungstag der Anmeldung: 23.04.1997
(73) Patentinhaber: SIEMENS AKTIENGESELLSCHAFT, 80333 München (DE)
(72) Erfinder: BURGHARDT, Hartmut, D-83607 Holzkirchen (DE); SCHRECK, Hans-Günther, D-80801 München (DE); GRUHLER, Ulrich, D-80689 München (DE)
(86) Internationale Anmeldenummer: DE9500823
(87) Internationale Veröffentlichungsnummer: WO9601437

(56) Entgegenhaltungen:
- EP-A- 0 494 759
- EP-A- 0 511 779
- EP-A- 0 604 050
- FR-A- 2 681 755

## Beschreibung

Der Anmeldungsgegenstand betrifft eine Vorrichtung mit einem Baugruppenträger zur Aufnahme von Baugruppen, bei dem
- der Baugruppenträger (BGT) eine Anzahl von Baugruppenplätzen (BGP), in die jeweils eine Baugruppe einsteckbar ist, aufweist
- jede Baugruppe über einen optische Signale weiterleitenden Lichtwellenleiter und einen Vielfachsteckverbinder (VFS) mit einer anderen Baugruppe lösbar verbunden ist.

Eine Vorrichtung mit den angegebenen Merkmalen ist aus der EP 0511779 bekannt.

In einem Baugruppenträger werden mehrere Baugruppen zu einer mechanisch stabilen Einheit zusammengefaßt. Baugruppen, die optische Signale empfangende oder aussendende Komponenten aufweisen, müssen über optische Signale transportierende Lichtwellenleiter mit anderen Baugruppen verbunden werden. Bei einer Realisierung der Verbindungen mit einzelnen Lichtwellenleitern macht sich ein hoher Fertigungsaufwand bemerkbar, wobei für Baugruppenträger mit unterschiedlicher Verbindungsstruktur diese Struktur zu berücksichtigen ist und zudem eine ständige Gefahr von Vertauschungen gegeben ist. Bei einer herkömmlichen Realisierung der Verdrahtung unter Verwendung von Lichtwellenleiter-Leitungsbündeln macht es sich nachteilig bemerkbar, daß die Enden der einzelnen Lichtwellenleiter im allgemeinen verschiedenen Baugruppen zugeführt werden müssen, so daß das Lichtwellenleiter-Leitungsbündel aufwendig aufgetrennt werden muß.

Bei dem aus der EP 0511779 bekannten Baugruppenträger ist das optische Ausgangselement jeder Baugruppe mit allen Eingangselementen der anderen Baugruppen verbunden. Dieses Konzept erfordert auf den einzelnen Baugruppen eine Selektion der für sie bestimmten Informationen.

Der Anmeldung liegt das Problem zugrunde, eine besondere Ausgestaltung für die Verbindungen zwischen den Baugruppen eines Baugruppenträgers anzugeben, die weitgehend standardisiert, einfach und fehlerfrei herstellbar ist und zudem eine Zuführung nur der Informationen, die für die betreffende Baugruppe bestimmt sind, ermöglicht.

Das Problem wird bei der eingangs genannten Vorrichtung dadurch gelöst, daß
- an einem Baugruppenplatz (BGP) eine jeweilige Rangierbaugruppe (RBG) einsteckbar ist,
- jede Baugruppe über ein Lichtwellenleiter-Bündel (LLB) und einen Vielfachsteckverbinder mit der Rangierbaugruppe lösbar verbunden ist,
- die jeweilige Rangierbaugruppe derart ausgebildet ist, daß zwischen den einzelnen Lichtwellenleitern der mit der Rangierbaugruppe verbundenen Lichtwellenleiter-Bündel eine jeweilige Zuordnung von Verbindungen gegeben ist.

Die erfindungsgemäße Vorrichtung ist im Anspruch 1 definiert.

Der Anmeldungsgegenstand bringt eine einfache Anschließbarkeit einer Baugruppe des Baugruppenträgers in einem einzigen Arbeitsgang unter Ausschluß von Vertauschungen mit sich. Für unterschiedliche Baugruppenträger können für die Verbindungen zwischen den Baugruppen und der Rangierbaugruppe einheitliche Verbindungsleitungen gegeben sein, wobei die Zuordnung der einzelnen Wellenleiter allein durch die Rangierbaugruppe gegeben ist. Durch einen Austausch der steckbar angeordneten Rangierbaugruppe gegen eine eine andere Zuordnung der einzelnen Verbindungen aufweisende Rangierbaugruppe ist eine einfache Möglichkeit zur Änderung der Zuordnung der Verbindungen der Baugruppen eines Baugruppenträgers gegeben. Der Anmeldungsgegenstand bringt also eine Standardisierung der Verbindungen zwischen Baugruppen für Baugruppenträger mit unterschiedlicher Verbindungsfunktion mit sich, womit der Baugruppenträger in einem größeren Umfang vorfertigbar ist. Die dem Baugruppenträger zugeführten und die von dem Baugruppenträger weitergeleiteten optischen Signale werden grundsätzlich über zwei Stufen, d.h. über die Rangierbaugruppe und die betreffende Baugruppe geführt, so daß die Dynamikanforderungen an die Eingangsstufe des Empfängers der optischen Signale gegenüber Anordnungen, bei denen die optischen Signale teils über nur eine Stufe und teils über zwei Stufen geführt sind, verringert sind. Beim Anmeldungsgegenstand bewirkt die Rangierbaugruppe eine eindeutige Zuordnung der Verbindungen zwischen den einzelnen Lichtwellenleitern der mit der Rangierbaugruppe verbundenen Lichtwellenleiter-Bündel.

Die Erfindung wird nun als Ausführungsbeispiel in einem zum Verständnis erforderlichen Umfang anhand einer Figur näher beschrieben.

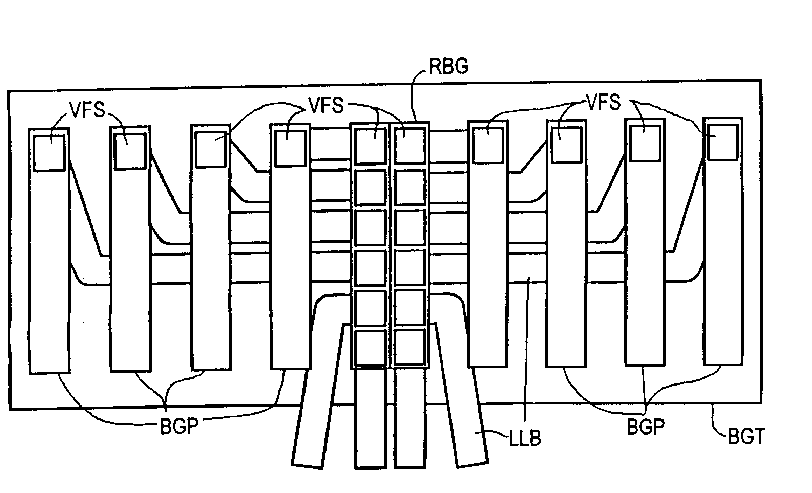

Dabei zeigt FIG 1 eine schematische Darstellung des erfindungsgemäßen Baugruppenträgers.

FIG 1 läßt den Umriß eines für sich genommen bekannten Baugruppenträgers BGT erkennen, der eine Anzahl, insbesondere eine Mehrzahl, von Baugruppen an dafür vorgesehenen Baugruppenplätzen BGP aufzunehmen vermag. Die Baugruppen empfangen über optische Wellenleiter Signale bzw. leiten Signale über optische Wellenleiter weiter. In dem hier interessierenden Zusammenhang mögen die Signale auf den Baugruppen in beliebiger Weise verarbeitet werden. Darüber hinaus nimmt der Baugruppenträger erfindungsgemäß eine Rangierbaugruppe RBG auf. Jede Baugruppe ist über einen Vielfachsteckverbinder VFS und ein Lichtwellenleiter-Leitungsbündel mit der Rangierbaugruppe lösbar verbunden. Dabei mag ein Lichtwellenleiter-Leitungsbündel, das auch als Faserarray oder als Faserbändchen bezeichnet wird, durch einen handelsüblichen Steckerverbinder abgeschlossen sein, der eine gleichzeitige Verbindung oder Trennung einer Mehrzahl von Wellenleitern zu bewirken vermag. Die Lichtwellenleiter-Leitungsbündel und Vielfachsteckverbinder, die die Baugruppen mit der Rangierbaugruppe verbinden weisen vorzugsweise untereinander identische Bauart auf. Durch konstruktive Maßnahmen mag sichergestellt sein, daß im Zuge eines Verbindungsvorgangs der beiden zusammenwirkenden Teile eines Vielfachsteckverbinders, wie z.B. Stecker und Kupplung bzw. Buchse, die einzelnen Wellenleiter eines Lichtwellenleiter-Leitungsbündels nur im zugeordneten Sinn mit den entsprechenden Wellenleitern verbindbar sind.

Bei einer Ausführungsform ist das einer Baugruppe zugehörige Lichtwellenleiter-Leitungsbündel baugruppenseitig mit der Baugruppe fest verbunden und auf seiten der Rangierbaugruppe durch einen Vielfachsteckverbinder abgeschlossen. Dabei mag der Vielfachsteckverbinder auf seiten des Lichtwellenleiter-Leitungsbündels durch einen Stecker und auf seiten der Rangierbaugruppe durch eine mit dem Stecker zusammenwirkende Kupplung oder eine unmittelbar auf der Rangierbaugruppe befestigte Buchse gegeben sein.

Bei einer anderen Ausführungsform sind die zu den einzelnen Baugruppen führenden Lichtwellenleiter-Leitungsbündel auf seiten der Rangierbaugruppe fest mit der Rangierbaugruppe verbunden und baugruppenseitig jeweils durch einen Vielfachsteckverbinder abgeschlossen. Dabei mag der Vielfachsteckverbinder auf seiten des Lichtwellenleiter-Leitungsbündels durch einen Stecker und baugruppenseitig durch eine mit dem Stecker zusammenwirkende Kupplung oder eine unmittelbar auf der Baugruppe befestigte Buchse gegeben sein.

Bei einer bevorzugten Ausführungsform sind die einzelnen Lichtwellenleiter-Leitungsbündel an ihren beiden Enden mit untereinander gleichen Vielfachsteckverbindern abgeschlossen. Dabei mögen die Vielfachsteckverbinder auf seiten eines Lichtwellenleiter-Leitungsbündels durch Stecker und auf seiten der Baugruppe bzw. der Rangierbaugruppe durch jeweils eine mit dem Stecker zusammenwirkende Kupplung oder eine unmittelbar auf der Baugruppe bzw. der Rangierbaugruppe befestigte Buchse gegeben sein. Diese Maßnahme bringt eine Verwendbarkeit von untereinander gleichen Verbindungsleitungen zwischen den einzelnen Baugruppen und der Rangierbaugruppe mit sich.

In weiterer Ausgestaltung ist der ein Lichtwellenleiter-Leitungsbündel abschließende Teil einer Vielfachsteckverbindung, z.B. der Stecker, bezüglich seiner Position mit dem Baugruppenträger fixiert. Durch diese Maßnahme wird eine Verbindung bzw. Trennung einer Baugruppe mit bzw. von dem zugehörigen Lichtwellenleiter-Leitungsbündel beim Einführen bzw. bei der Entnahme der Baugruppe in bzw. aus dem Baugruppenträger bewirkt.

Die Rangierbaugruppe ist bevorzugt an einem mittleren Platz innerhalb des Baugruppenträgers angeordnet. Werden für einen Baugruppenträger untereinander gleiche, standardisierte Lichtwellenleiter-Leitungsbündel vorgesehen, so macht es sich dabei vorteilhaft bemerkbar, daß die vorzusehende Länge der Lichtwellenleiter-Leitungsbündel ein Minimum erreicht.

Die Rangierbaugruppe ist - neben den mit Baugruppen desselben Baugruppenträgers verbundenen Lichtwellenleiter-Leitungsbündeln - mit Lichtwellenleiter-Leitungsbündeln verbunden, die Signale von bzw. zu außerhalb des betrachteten Baugruppenträgers befindlichen Einrichtungen empfangen bzw. weiterleiten. Diese Einrichtungen können wiederum selbst durch Baugruppenträger gegeben sein.

Die Rangierbaugruppe ist also über eine Mehrzahl von jeweiligen Vielfachsteckverbindern und Lichtwellenleiter-Leitungsbündeln sowohl mit Baugruppen desselben Baugruppenträgers als auch mit Einrichtungen außerhalb des betrachteten Baugruppenträgers verbunden. Die Vielfachsteckverbinder sind vorzugsweise untereinander identischer Bauart. Die Lichtwellenleiter-Leitungsbündel weisen vorzugsweise untereinander die gleiche Anzahl von Wellenleitern auf.

Die Rangierbaugruppe hat die Funktion der Zuordnung der Verbindungen zwischen den einzelnen Wellenleitern der mit der Rangierbaugruppe verbundenen Lichtwellenleiter-Leitungsbündel. Die Rangierbaugruppe ordnet also die einzelnen Wellenleiter sowohl zwischen den Baugruppen eines Baugruppenträgers als auch zwischen Einrichtungen außerhalb des Baugruppenträgers und Baugruppen des Baugruppenträgers zu. In einer einfachen Ausführungsform ist die Zuordnung der Verbindungen auf der Rangierbaugruppe nur mit Wellenleitern ausgeführt. In einer weiteren Ausführungsform kann die Rangierbaugruppe Splitter und/oder Combiner zur Verzweigung bzw. Zusammenführung von optischen Signalen aufweisen. In weiterer Ausgestaltung kann die Rangierbaugruppe aktive Elemente, wie z.B. optische Verstärker, zur Verstärkung von geschwächten optischen Signalen und/oder zur Regenerierung von empfangenen oder weiterzuleitenden Signalen aufweisen

In weiterer Ausgestaltung weist die Rangierbaugruppe ein für den betrachteten Baugruppenträger zentrales Element auf; ein zentrales Element kann durch eine Lichtquelle, wie z.B. eine Laserdiode gegeben sein, die Taktsignale, Steuerinformationen oder cw(continuous wave)-Licht, d.h. ein andauerndes optisches Signal, abgibt.

In weiterer Ausgestaltung ist die Zuordnung der Verbindungen auf der Rangierbaugruppe schaltbar. Als Schalterelemente können beliebige optische Schalter wie z.B. an sich bekannte LCD(Liquid Cristal Display)-Elemente, oder lineare polymere Lichtwellenleiter zum Einsatz kommen. Besonders vorteilhaft ist die Kombination eines linearen polymeren Lichtwellenleiters mit einem in dem selben Material hergestellten Thermoschalter. Das Zusammenwirken des linearen polymeren Wellenleiters mit dem Thermoschalter bringt eine Schaltbarkeit der Zuordnung der einzelnen Verbindungen durch der Rangierbaugruppe zugeführte elektrische Steuersignale mit sich. Eine Zuordnung durch elektrische Steuersignale ist auch bei einem elektrisch angesteuerten nichtlinearen polymeren Lichtwellenleiter gegeben.

Beim Anmeldungsgegenstand können mehrere optische Signale unterschiedlicher Wellenlänge im Wellenlängenmultiplex auf einem Wellenleiter eines Lichtwellenleiter-Leitungsbündels übertragen werden. Zur Trennung bzw. Zusammenführung solcher Signale können auf einer Baugruppe oder auf der Rangierbaugruppe wellenlängenselektive Elemente wie z.B. Hologramme zum Einsatz kommen.

Für Prüfungszwecke ist anstelle der Rangierbaugruppe eine Analysebaugruppe steckbar, auf der eine Auswerte- und Anzeigeeinrichtung angeordnet ist oder die mit einer außerhalb des Baugruppenrahmens angeordneten Auswerte- und Anzeigeeinrichtung verbunden ist. Diese Maßnahme bringt eine vereinfachte Fehlersuche und damit eine verkürzte Fehlerbehebung mit sich.

## Patentansprüche

1. Vorrichtung zur Verbindung von Baugruppen mit einem Baugruppenträger (BGT) zur Aufnahme von Baugruppen, der eine Anzahl von Baugruppenplätzen (BGP) aufweist, mit einer Anzahl von Baugruppen, die auf entsprechenden Baugruppenplätzen steckbar angeordnet sind, und mit einer jeweiligen Rangierbaugruppe (RGB), die an einem Baugruppen platz steckbar angeordnet ist, wobei
jede Baugruppe über ein Lichtwellenleiter-Bündel (LLB) und einen Vielfachsteckverbinder mit der Rangierbaugruppe lösbar verbunden ist, und wobei
die jeweilige Rangierbaugruppe derart ausgebildet ist, daß zwischen den einzelnen Lichtwellenleitern der mit der Rangierbaugruppe verbundenen Lichtwellenleiter-Bündel eine jeweilige Zuordnung von Verbindungen gegeben ist, so daß die optische Verbindung der einzelnen Lichtwellenleiter untereinander allein durch die Raugierbaugruppe gegeben ist.

2. Vorrichtung nach Anspruch 1, bei der
eine jeweilige Baugruppe über ein an seinen beiden Enden jeweils einen Vielfachsteckverbinder aufweisendes Lichtwellenleiter-Bündel mit der Rangierbaugruppe lösbar verbunden ist.

3. Vorrichtung nach Anspruch 2, bei der
eine jeweilige Baugruppe und die Rangierbaugruppe jeweils einen unmittelbar auf ihr befestigten Teil des Vielfachsteckers aufweist.

4. Vorrichtung nach Anspruch 3, wobei
der ein Ende eines jeweiligen Lichtwellenleiter -Bündels abschließende Teil der Vielfachsteckverbindung ein Stecker ist und der mit einer jeweiligen Baugruppe oder der Rangierbaugruppe verbundene Teil der Steckverbindung eine mit dem Stecker zusammenwirkende Buchse ist.

5. Vorrichtung nach einem der vorstehenden Ansprüche, bei der die Rangierbaugruppe im wesentlichen einen mittleren Einbauplatz zwischen den Baugruppen einnimmt.

6. Vorrichtung nach einem der vorstehenden Ansprüche, bei der sämtliche Vielfachsteckverbinder untereinander die gleiche Bauart aufweisen.

7. Vorrichtung nach einem der vorstehenden Ansprüche, bei der die Rangierbaugruppe eine Anzahl von Vielfachsteckverbindern aufweist, die jeweils über Lichtwellenleiter-Bündel mit außerhalb des Baugruppenträgers befindlichen Einrichtungen verbindbar sind.

8. Vorrichtung nach einem der vorstehenden Ansprüche, wobei der einer Baugruppe oder der Rangierbaugruppe zugewandte Teil der Vielfachsteckverbindung fest mit der Baugruppe oder Rangierbaugruppe und der der Baugruppe oder Rangierbaugruppe abgewandte Teil der Vielfachsteckverbindung fest mit dem Baugruppenträger verbunden ist.

9. Vorrichtung nach einem der vorstehenden Ansprüche, bei der die Verbindungsfunktion auf der Rangierbaugruppe zwischen den mit der Rangierbaugruppe verbundenen Lichtwellenleiter-Bündeln nur mit Lichtwellenleitern bewirkt ist.

10. Vorrichtung nach einem der Ansprüche 1 bis 8, bei der die Verbindungsfunktion auf der Rangierbaugruppe zwischen den mit der Rangierbaugruppe verbundenen Lichtwellenleiter-Bündeln mit optische Signale zusammenführende und /oder aufteilende Combiner bzw. Splitter bewirkt ist.

11. Vorrichtung nach einem der vorstehenden Ansprüche, bei der die Zuordnung der Verbindungen auf der Rangierbaugruppe zwischen den mit der Rangierbaugruppe verbundenen Lichtwellenleiter-Bündeln durch eine Schaltfunktion aufweisende Elemente bewirkt ist.

12. Vorrichtung nach Anspruch 11, bei der das die Schaltfunktion bewirkende Element durch einen linearen polymeren Wellenleiter gegeben ist, der mit einem in dem selben Material realisierten Thermoschalter zusammenwirkt.

13. Vorrichtung nach Anspruch 11, bei der das die Schaltfunktion bewirkende Element durch einen nichtlinearen polymeren Wellenleiter gegeben ist, der mittels elektrischer Signale ansteuerbar ist.

14. Vorrichtung nach einem der Ansprüche 11, 12 oder 13, bei der für die einzelnen Lichtwellenleiter Ersatzwege schaltbar sind.

15. Vorrichtung nach einem der vorstehenden Ansprüche, bei der auf einem Wellenleiter eines Lichtwellenleiter-Bündels mehrere optische Signale unterschiedlicher Wellenlänge übertragbar sind und zur Trennung bzw. Zusammenführung dieser Signale auf einer Baugruppe oder der Rangierbaugruppe ein wellenlängenselektives Element angeordnet ist.

16. Vorrichtung nach einem der vorstehenden Ansprüche, bei der die Rangierbaugruppe ein für mehrere Baugruppen gemeinsames zentrales Element aufweist.

17. Vorrichtung nach Anspruch 16, bei der das zentrale Element durch eine Laserdiode gegeben ist.

## Claims

1. Device for connecting modules, having a subrack (BGT) to accommodate modules, the said subrack having a number of module spaces (BGP) having a number of modules which are arranged so that they can be plugged onto corresponding module spaces, and having a respective routing module (RBG), which is arranged so that it can be plugged on at a module space, each module being detachably connected to the routing module via a bundle of optical fibres (LLB) and a multiple-plug connector, and the respective routing module being constructed in such a way that a respective assignment of connections is provided between the individual optical fibres in the bundle of optical fibres connected to the routing module, so that the optical interconnection of the individual optical fibres is provided only by the routing module.

2. Device according to Claim 1, in which a respective module is detachably connected to the routing module via a bundle of optical fibres having a multiple-plug connector at each of its two ends.

3. Device according to Claim 2, in which a respective module and the routing module in each case have a part of the multiple-plug connector fastened directly on them.

4. Device according to Claim 3, the part of the multiple plug connection terminating one end of a respective bundle of optical fibres being a plug and the part of the plug connection connected to a respective module or the routing module being a socket cooperating with the plug.

5. Device according to one of the preceding claims, in which the routing module essentially assumes a central installation space.

6. Device according to one of the preceding claims, in which all the multiple-plug connectors have a mutually identical construction.

7. Device according to one of the preceding claims, in which the routing module has a number of multiple-plug connectors which can in each case be connected via bundles of optical fibres to devices located outside the subrack.

8. Device according to one of the preceding claims, the part of the multiple plug connection facing a module or the routing module being firmly connected to the module or routing module and the part of the multiple plug connection facing away from the module or routing module being firmly connected to the subrack.

9. Device according to one of the preceding claims, in which the connecting function on the routing module between the bundles of optical fibres connected to the routing module is effected only using optical fibres.

10. Device according to one of Claims 1 to 8, in which the connecting function on the routing module between the bundles of optical fibres connected to the routing module is effected using combiners and/or splitters which combine or split optical signals.

11. Device according to one of the preceding claims, in which the assignment of the connections on the routing module between the bundles of optical fibres connected to the routing module is effected by elements having a switching function.

12. Device according to Claim 11, in which the element effecting the switching function is provided by a linear polymeric waveguide which cooperates with a thermal switch made in the same material.

13. Device according to Claim 11, in which the element effecting the switching function is provided by a non-linear polymeric waveguide which can be activated by means of electrical signals.

14. Device according to one of Claims 11, 12 or 13, in which substitute paths can be switched for the individual optical fibres.

15. Device according to one of the preceding claims, in which it is possible to transmit a plurality of optical signals of different wavelengths on one waveguide of a bundle of optical fibres, and a wavelength-selective element is arranged on a module or the routing module in order to separate or combine these signals.

16. Device according to one of the preceding claims, in which the routing module has a central element which is common to a plurality of modules.

17. Device according to Claim 16, in which the central element is provided by a laser diode.

## Revendications

1. Dispositif pour le raccordement de modules, avec un châssis (BGT) pour accueillir des modules, qui comporte un certain nombre d'emplacements de modules (BGP), avec un certain nombre de modules, placés d'une façon enfichable dans des emplacements correspondants, et avec un module de connexion (RGB) respectif, placé d'une façon enfichable dans un emplacement de module,
chaque module étant relié, d'une façon amovible, avec le module de connexion par l'intermédiaire d'un faisceau (LLB) de guides d'ondes optiques et d'un connecteur multiple enfichable et
chaque module de connexion étant conçu de telle sorte qu'une affectation respective de liaisons est donnée entre les différents guides d'ondes optiques du faisceau de guides d'ondes optiques raccordé au module de connexion, si bien que la liaison optique des différents guides d'ondes optiques est déterminée uniquement par le module de connexion.

2. Dispositif selon la revendication 1 dans lequel
chaque module est relié, d'une façon amovible, au module de connexion par l'intermédiaire d'un faisceau de guides d'ondes optiques comportant à ses deux extrémités un connecteur multiple enfichable.

3. Dispositif selon la revendication 2 dans lequel
chaque module et le module de connexion comportent respectivement une partie du connecteur multiple, qui est fixée directement sur chaque module.

4. Dispositif selon la revendication 3 dans lequel
la partie de la connexion multiple enfichable terminant une extrémité de chaque faisceau de guides d'ondes optiques est une fiche mâle et la partie de la connexion enfichable reliée à un module correspondant ou au module de connexion est une douille correspondant à la fiche mâle.

5. Dispositif selon l'une des revendications précédentes dans lequel
le module de connexion occupe essentiellement un emplacement central entre les modules.

6. Dispositif selon l'une des revendications précédentes dans lequel
tous les connecteurs multiples enfichables présentent réciproquement le même mode de construction.

7. Dispositif selon l'une des revendications précédentes dans lequel
le module de connexion comporte un certain nombre de connecteurs multiples enfichables qui peuvent chacun être reliés, par l'intermédiaire de faisceaux de guides d'ondes optiques, à des dispositifs qui se trouvent à l'extérieur du châssis.

8. Dispositif selon l'une des revendications précédentes dans lequel
la partie de la connexion multiple enfichable tournée vers un module ou vers le module de connexion est reliée d'une façon définitive au module ou au module de connexion et la partie de la connexion multiple enfichable opposée au module ou au module de connexion est reliée d'une façon définitive au châssis.

9. Dispositif selon l'une des revendications précédentes dans lequel
la fonction de connexion, sur le module de connexion, entre les faisceaux de guides d'ondes optiques reliés au module de connexion, est exécutée uniquement par les guides d'ondes optiques.

10. Dispositif selon l'une des revendications 1 à 8 dans lequel
la fonction de connexion, sur le module de connexion, entre les faisceaux de guides d'ondes optiques reliés au module de connexion, est exécutée par des "combiner" ou assembleurs et/ou des "splitter" ou séparateurs pour l'addition et/ou la dérivation de signaux optiques.

11. Dispositif selon l'une des revendications précédentes dans lequel
l'affectation des liaisons sur le module de connexion, entre les faisceaux de guides d'ondes optiques reliés au module de connexion, est exécutée par des éléments comportant une fonction de commutation.

12. Dispositif selon la revendication 11 dans lequel
l'élément exécutant la fonction de commutation est constitué par un guide d'ondes polymère linéaire qui a une interaction avec un thermorupteur réalisé avec le même matériau.

13. Dispositif selon la revendication 11 dans lequel
l'élément exécutant la fonction de commutation est constitué par un guide d'ondes polymère non linéaire qui peut être excité au moyen de signaux électriques.

14. Dispositif selon l'une des revendication 11, 12 ou 13 dans lequel
on peut commuter des cheminements de remplacement pour les différents guides d'ondes optiques.

15. Dispositif selon l'une des revendications précédentes dans lequel
plusieurs signaux optiques de longueurs d'ondes différentes peuvent être transmis sur un guide d'ondes d'un faisceau de guides d'ondes optiques et dans lequel un élément sélectif des longueurs d'ondes est monté sur un module ou sur le module de connexion pour la séparation ou l'assemblage de ces signaux.

16. Dispositif selon l'une des revendications précédentes dans lequel
le module de connexion comporte un élément central commun pour plusieurs modules.

17. Dispositif selon la revendication 16 dans lequel
l'élément central est constitué par une diode laser.
